# EUROPEAN PATENT APPLICATION

(11) **EP 4 818 705 A1**
(43) Date of publication of application: **07.10.2026**
(21) Application number: 26165006.3
(22) Date of filing: 16.03.2026
(51) Int. Cl.: G01P 15/125, B81B 3/00, B81C 1/00, G01P 15/08

(54) **MICROELECTROMECHANICAL DEVICE WITH MEANS FOR OVERCOMING STICKING CONDITIONS**

(30) Priority: 31.03.2025 IT 202500006822
(71) Applicant: STMicroelectronics International N.V., 1228 Plan-les-Ouates, Geneva (CH)
(72) Inventor: LUBERTO, Alessandro, 20864 AGRATE BRIANZA (MB) (IT); FEDELI, Patrick, 20864 AGRATE BRIANZA (MB) (IT); FOLETTO, Laura, 20864 AGRATE BRIANZA (MB) (IT)
(74) Representative: Studio Torta S.p.A.

(57) **Abstract**

A microelectromechanical device includes: a support body (10); a movable mass (11), having a semiconductor main body (11a), constrained to the support body (10) by first flexures (12) to be able to oscillate according to a main motion direction (X); and recovery electrodes (20) are arranged on the support body (10). The movable mass (11) compreise a plurality of semiconductor auxiliary bodies (11b), constrained to the main body (11a) by second flexures (18). The second flexures (18) prevent relative movements of the auxiliary bodies (11b) with respect to the main body (11a) according to the main motion direction (X) at least in an operating frequency band (B_{OP}) and allow relative movements of the auxiliary bodies (11b) with respect to the main body (11a) according to an actuation degree of freedom (R1, R2) in a recovery frequency band (B_{R}) higher than the operating frequency band (B_{OP}). The recovery electrodes (20) are capacitively coupled to the respective auxiliary bodies (11b).

## Description

### Technical Field

The present invention relates to a micro-electromechanical (MEMS) device with recovery from stiction conditions.

### Background

As is known, microelectromechanical devices such as accelerometers and gyroscopes normally use movable masses connected to a support body by elastic connections or "flexures". Flexures allow the oscillation of the movable mass along one or more directions in response to external stresses or by the action of a driver, as in gyroscopes.

Following intense stresses, the movable mass may come into contact with the support structure and stick thereto without being able to spontaneously return to its rest position. The energy transferred in the impact may create surface bonds that need to be broken by applying a suitable additional force to release the movable mass, because the elastic force of the flexures may not be sufficient.

The phenomenon, known as "stiction", is relatively frequent in microelectromechanical devices and, although being more common in accelerometers, it is not excluded also for gyroscopes, both in the drive part and in the sense part. Accelerometers are however more easily subject to the problem because the flexures are less stiff to allow wider oscillations given the same amplitude of the stresses and, therefore, a higher sensitivity.

The problem of stiction is serious and is particularly felt because it may compromise the operation of the microelectromechanical device. Evidently, as long as the movable mass sticks to the support body, the microelectromechanical device is not in a condition to operate and not always may functionality of the movable mass be recovered.

A known solution consists in applying an electrostatic force contrary to the stiction force of the movable mass to the support body. Generally, the stiction force is parallel to the main oscillation direction of the movable mass and may be overcome for example by using the same electrodes that normally serve for sensing. In many cases, however, the intervention is not decisive. In fact, the same force needed to separate the movable mass from the support body is actually sufficient to cause the movable mass to stick to the opposite side of the support body and the functionality of the microelectromechanical device may not in effect be recovered.

It has also been proposed to combine an electrostatic force contrary to the stiction force with transversal forces, applied by specific electrodes in an attempt to solicit transversal vibration eigenmodes of the structure. When this occurs, the movable mass may be subject to a resulting force greater than the stiction force, but with a lower component along the motion direction of the movable mass. In this manner, the detachment of the movable mass may be obtained and the stiction on the opposite side of the support body may be avoided. However, the solution may be difficult to control and, in some cases, not effective. The vibration eigenmodes and the stiction forces are in fact not known a priori. Therefore, the vibration eigenmodes might not be excited by the electrostatic forces or may not be present at all with characteristics such as to contribute sufficiently to the detachment of the movable mass. Furthermore, even in case the release attempt is successful, the trajectory of the movable mass is not well predictable and may still cause shocks and damage to the microstructure.

Other solutions include applying an anti-stiction coating or designing stoppers having shape and position such as to make stiction less likely. In this manner, the frequency of stiction events may be decreased, but there are no substantial benefits when stiction does occur. Anti-stiction coatings may also present issues from the point of view of pollution and compliance with environmental regulations.

DE 10 2021 200147 A1 discloses a microelectromechanical device comprising a support body, a movable mass, having a semiconductor main body, constrained to the support body by flexures to be able to oscillate according to a main motion direction, and recovery electrodes arranged on the support body.

Other examples of known microelectromechanical devices are disclosed in US 2014/345380 A1 and in Baehr Ulrich et al.: "Frequency Induced Stiction for MEMS Accelerometers" JOURNAL OF MICROELECTROMECHANICAL SYSTEMS, IEEE SERVICE CENTER, US, VOL. 29, NO. 3, 1 JUNE 2020 (2020-06-01), pages 285-295.

### Summary

It is therefore an aim of the present invention to provide a microelectromechanical device and a method for manufacturing a microelectromechanical device that allow to overcome or at least mitigate the described limitations.

According to the present invention, a microelectromechanical device and a process for manufacturing a microelectromechanical device are provided, as defined in claims 1 and 8, respectively.

### Brief Description of the Figures

For a better understanding of the present invention, preferred embodiments are presented, by way of non-limiting example, with reference to the attached drawings, wherein:
- Figure 1 is a simplified block diagram of a microelectromechanical device in accordance with an embodiment of the present invention;
- Figure 2 is a plot showing quantities relating to the microelectromechanical device of Figure 1;
- Figure 3 is a top-plan view of a part of the microelectromechanical device of Figure 1, in a first operating configuration;
- Figure 4 is a top-plan view of the microelectromechanical device of Figure 3, in a second operating configuration;
- Figure 5 is a cross-section through the microelectromechanical device of Figure 3, taken along line V-V of Figure 3;
- Figure 6 is a section through the microelectromechanical device of Figure 3, taken along line VI-VI of Figure 4;
- Figure 7 is a cross-section through the microelectromechanical device of Figures 3 and 4, taken along line VII-VII of Figure 3, in the first operating configuration;
- Figure 8 is a cross-section through the microelectromechanical device of Figures 3 and 4, taken along line VIII-VIII of Figure 4, in the second operating configuration;
- Figure 9 is a cross-section through the microelectromechanical device of Figures 3 and 4, taken along line VIII-VIII of Figure 4, in a third operating configuration;
- Figure 10 is a plot showing quantities relating to the microelectromechanical device of Figure 1;
- Figure 11 is a section through a microelectromechanical device in accordance with a different embodiment of the present invention, in a first operating configuration;
- Figure 12 shows the view of Figure 11, with the microelectromechanical device in a second operating configuration;
- Figure 13 is a section through a microelectromechanical device in accordance with another embodiment of the present invention, in a first operating configuration;
- Figure 14 shows the view of Figure 13, with the microelectromechanical device in a second operating configuration;
- Figure 15 is a top-plan view of a microelectromechanical device in accordance with a further embodiment of the present invention, in a first operating configuration;
- Figure 16 is a top-plan view of the microelectromechanical device of Figure 15, in a second operating configuration;
- Figure 17 is a cross-section through the microelectromechanical device of Figure 15, taken along line XVII-XVII of Figure 15;
- Figure 18 is a top-plan view of a microelectromechanical device in accordance with a further embodiment of the present invention; and
- Figure 19 is a cross-section through the microelectromechanical device of Figure 18, taken along line XIX-XIX of Figure 18.

### Description of Embodiments

The following description refers to the arrangement shown in the drawings; consequently, expressions such as "above", "below", "upper", "lower", "top", "bottom", "right", "left" and the like relate to the accompanying Figures and are not to be construed in a limiting manner.

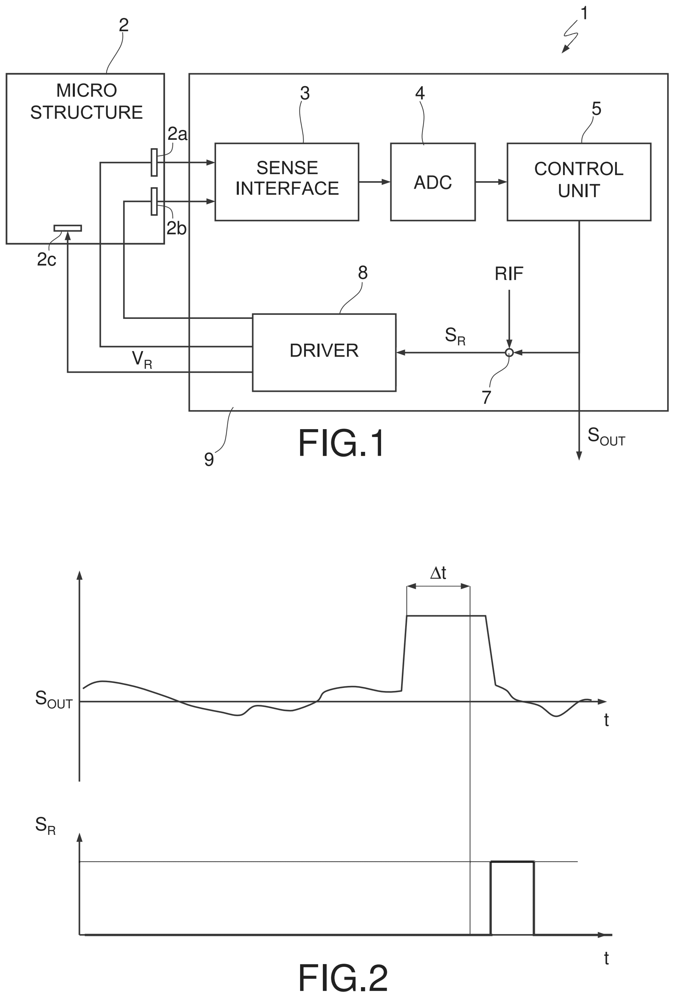

With reference to Figure 1, a microelectromechanical device is indicated as a whole with the number 1 and comprises a microstructure 2, a sense interface 3, an analog-to-digital converter 4, a control unit 5, a comparator stage 7 and a driver 8. The sense interface 3, the analog-to-digital converter 4, the control unit 5, the comparator stage 7 and the driver 8 may be components of a dedicated integrated circuit or ASIC (Application Specific Integrated Circuit) 9 coupled to the microstructure 2.

As specified below, in an embodiment which will be referred to for simplicity, the microelectromechanical device 1 is a linear uniaxial accelerometer of an in-plane-type, with a mass that is movable along a sense axis with respect to a support body (not shown in Figure 1). The microelectromechanical device 1 may however be any device provided with a mass movable with respect to a support body. In particular, the microelectromechanical device 1 may be an inertial sensor, for example a uniaxial accelerometer of the out-of-plane (or "teeter totter") type, a rotational accelerometer, a multiaxial accelerometer, a uniaxial or multiaxial gyroscope. Furthermore, the movable mass is generally a sense mass or seismic mass, but may also be a drive mass of a gyroscope.

The sense interface 3 receives sense signals from a first sense terminal 2a and a second sense terminal 2b of the microstructure 2, respectively, and provides amplified read signals, usable by the analog-to-digital converter 4 to generate digital sense signals.

The control unit 5 processes the digital sense signals and provides an output signal S_{OUT} indicative of a quantity sensed through the microstructure 2, here a linear acceleration along the sense axis.

The comparator stage 7 compares the output signal S_{OUT} with a reference value REF, that indicates a full-stroke position of the movable mass, and, when a stiction condition is recognized based on the comparison, generates a recovery signal S_{R}. When the recovery signal S_{R} indicates that a stiction condition has been recognized, the driver 8 applies a recovery voltage V_{R} to a recovery terminal 2c of the microstructure 2. The recovery voltage V_{R} is controlled to produce forces that cause the movable mass to detach, as explained below. In one embodiment, the recovery signal S_{R} may be generated for example when the comparison indicates that the movable mass has remained in the full-stroke position for a time greater than a threshold, as shown in Figure 2.

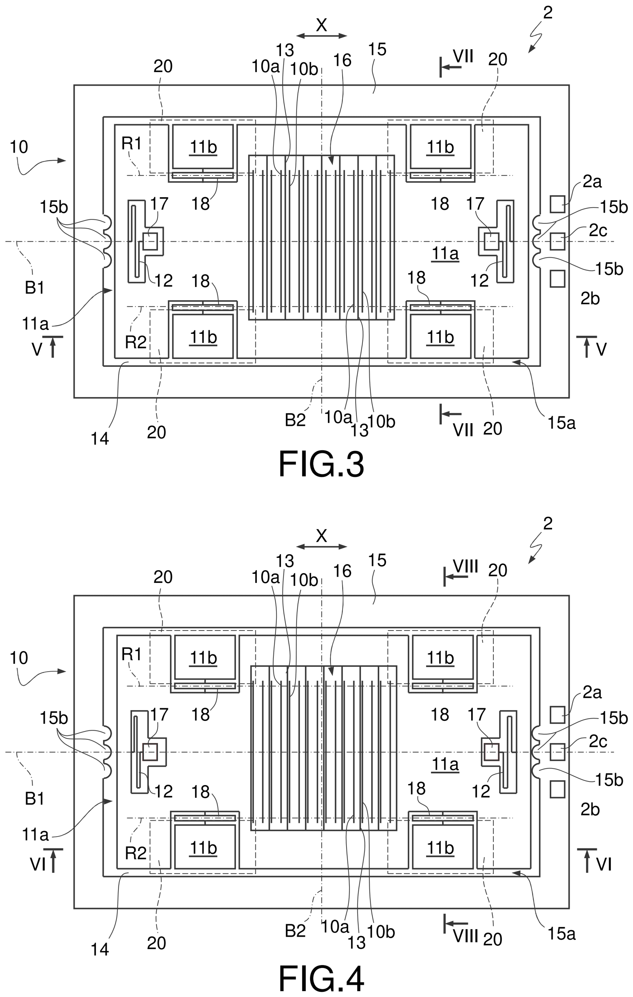

Figures 3 and 5 and Figures 4 and 6, where the support body is indicated by 10 and the movable mass by 11, show the microstructure 2 in a rest position and in a stiction condition, respectively. In the stiction condition, the movable mass 11 is held in a full-stroke position (on the right by way of example in Figure 4, but a similar situation may occur on the opposite side) by stiction forces FA.

In detail, the movable mass 11 is defined by a planar semiconductor plate and is connected to the support body 10 by main flexures 12, configured so that the movable mass 11 may oscillate with respect to the support body along a main motion direction X, that here coincides with the sense axis of the microelectromechanical device 1. In particular, the main motion direction X is parallel to a main face of the movable mass 11 and the movement of the movable mass 11 is of the in-plane type.

The support body 10 may comprise, for example, a substrate 14 of semiconductor material and a frame structure 15, defining a cavity 15a where the movable mass 11 is accommodated, at a distance from the substrate 14. The frame structure 15 is provided with stopper structures 15b adjacent to the side of the movable mass 11 opposite with respect to the main motion direction X. The stopper structures 15b then limit the movement of the movable mass 11 both in the main motion direction X (to the right in Figures 3 and 4) and in the opposite direction (to the left in Figures 3 and 4).

In the embodiment of Figures 3 and 4, the support body 10 and the movable mass 11 are capacitively coupled by sensing electrodes in a parallel-plate configuration. Alternatively, the sensing electrodes may be, for example, in a comb fingered configuration. More in detail, the support body 10 comprises first fixed sensing electrodes 10a and second fixed sensing electrodes 10b, coupled to the first sense terminal 2a and the second sense terminal 2b, respectively. The first fixed sensing electrodes 10a and the second fixed sensing electrodes 10b are anchored to the support body 10, for example to the substrate 14, and are defined by respective semiconductor plates perpendicular to the main motion direction X. The first fixed sensing electrodes 10a and the second fixed sensing electrodes 10b are arranged alternated and, in a non-limiting embodiment, are accommodated in a through cavity 16 of the movable mass 11.

The movable mass 11 is biased in a known manner to a working potential through the main flexures 12 and respective anchors 17 fixed to the substrate 14. The anchors 17 are electrically insulated from the rest of the support body 10 and are connected to an external bias source through connection lines and bias terminals not shown here for simplicity.

The movable mass 11 is provided with movable sensing electrodes 13, also defined by semiconductor plates perpendicular to the main motion direction X. The movable sensing electrodes 13 extend parallel to the main motion direction X through the through cavity 16 of the movable mass 11 and are each interposed between a respective first fixed sensing electrode 10a and a respective second fixed sensing electrode 10b, thus forming parallel-plate capacitors with differentially variable capacitance depending on the position of the movable mass 11.

The stopper structures 15b are shaped to stop the movable mass 11 before the movable sensing electrodes 13 come into contact with the first fixed sensing electrodes 10a or the second fixed sensing electrodes 10b, according to the motion direction of the movable mass 11.

The movable mass 11 comprises a main body 11a, that defines most of the same movable mass 11 and is coupled to the anchors 17 through the main flexures 12, and auxiliary bodies 11b, in turn elastically coupled to the main body 11a through respective auxiliary flexures 18. The main body 11a, the auxiliary bodies 11b and the auxiliary flexures 18 are of the same semiconductor material, for example obtained from a same structural layer of polycrystalline or monocrystalline silicon, and are at the same voltage. In the embodiment of Figures 3-6, in particular, the movable mass 11 comprises four auxiliary bodies 11b arranged symmetrically with respect to a first barycentric axis B1 and a second barycentric axis B2 respectively parallel and perpendicular to the main motion direction X and coplanar with a main face 11c of the main body 11a (that also defines a main face of the movable mass 11). Furthermore, the auxiliary bodies 11b are parallelepiped in shape. It is understood, however, that the number, shape, size and arrangement of the auxiliary bodies are not limiting, but may be chosen based on design preferences. In some embodiments, for example, the auxiliary bodies may be arranged asymmetrically.

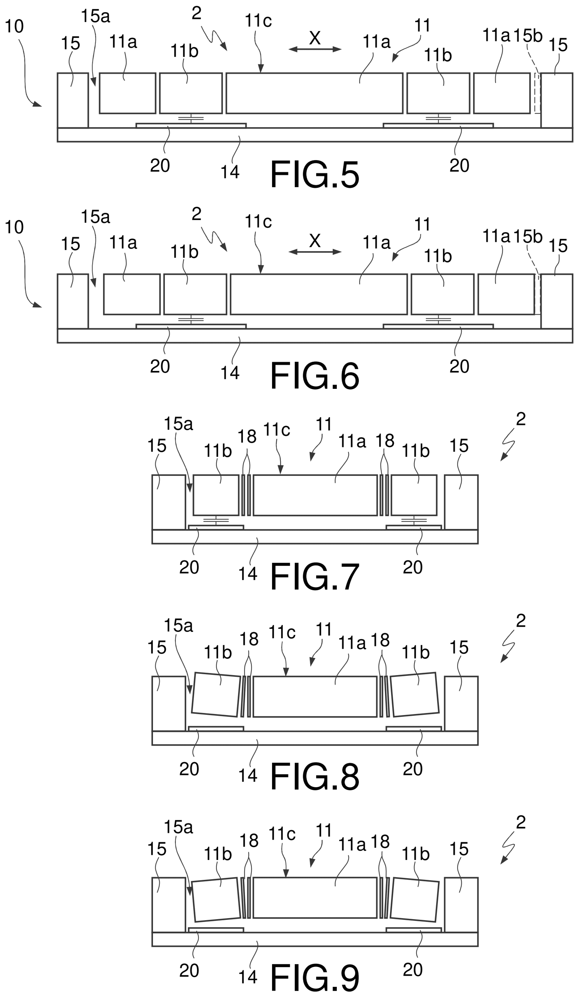

The auxiliary flexures 18 are configured so that the auxiliary bodies 11b are rigidly coupled to the main body 11a relative to the main motion direction X and movable in a direction that is transversal to the main motion direction X with respect to the main body 11a. For example, the auxiliary flexures 18 allow the auxiliary bodies 11b to rotate out-of-plane about rotation axes R1, R2 parallel to the first barycentric axis B1 and the main motion direction X (see also Figures 7-9).

The microstructure 2 is also provided with recovery electrodes 20, arranged on the support body 10 and coupled to respective auxiliary bodies 11b of the movable mass 11. More in detail, the recovery electrodes 20 are arranged to be capacitively coupled to the respective auxiliary bodies 11b at least when the movable mass 11 is in stiction conditions, against the stopper structures 15b on one side of the frame structure 15. In the embodiment of Figures 3-6, in particular, the recovery electrodes 20 are placed on the substrate 14 and have shape and size such as to always be capacitively coupled to the respective auxiliary bodies 11b. The recovery electrodes 20 are arranged so that an electrostatic force due to a voltage between the same recovery electrodes 20 and the respective auxiliary bodies 11b causes a displacement of the auxiliary bodies 11b transversely to the main motion direction X, according to the degree of freedom allowed by the auxiliary flexures 18.

The recovery electrodes 20 are further connected to the recovery terminal 2c of the microstructure 2 to apply a recovery voltage V_{R} to the respective auxiliary bodies 11b in response to a recovery signal S_{R} from the driver 8. The driver 8 and the recovery electrodes 20 form an actuator for recovering from stiction conditions.

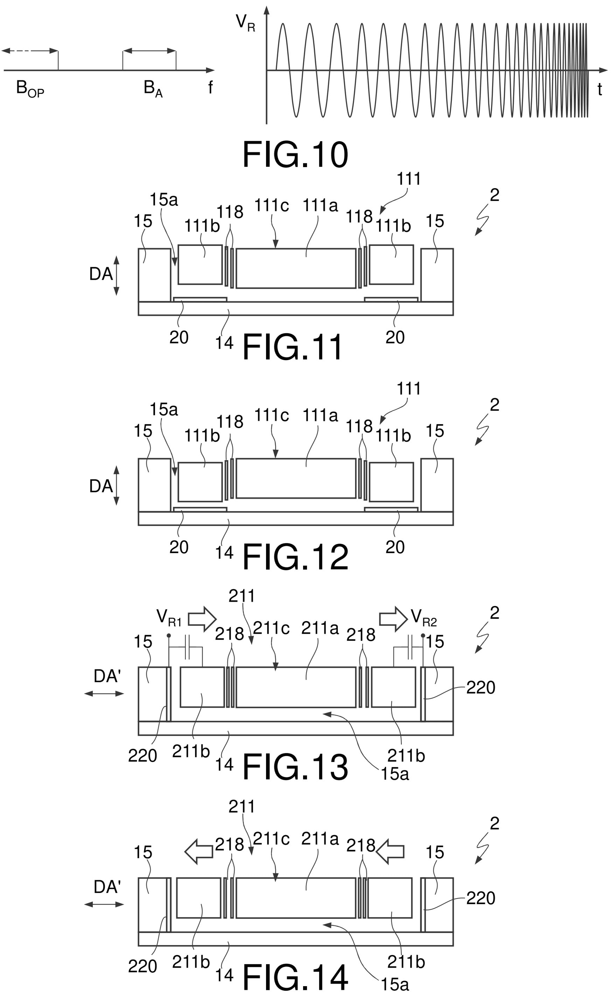

The recovery voltage V_{R} may be for example a sinusoidal or square-wave voltage with a frequency in a recovery band B_{A} higher than an operating band B_{OP} of the microelectromechanical device 1. In particular, the recovery voltage V_{R} may have a constant frequency, for example comprised between 50 kHz and 150 kHz, for example 100 kHz, or an increasing frequency to carry out a scan of a frequency range (Figure 10), for example from 50 kHz to 150 kHz. The lower limit of the recovery band B_{A} is at least one order of magnitude greater than the upper limit of the operating band B_{OP}.

The electrostatic forces applied to the auxiliary bodies 11b by the effect of the recovery voltage V_{R} cause oscillations of the auxiliary bodies 11b in a direction that is transversal with respect to the main motion direction X (in particular angular oscillations about rotation axes parallel to the first barycentric axis B1 and to the main motion direction X in the embodiment of Figures 3-9). The mechanical coupling between the auxiliary bodies 11b and the main body 11a of the movable mass defines respective damped oscillating systems and causes the main body 11a to vibrate, essentially in a direction perpendicular to the main motion direction X. The vibrations induced by the auxiliary bodies 11b in oscillation cause forces also perpendicular to the main motion direction X, that add to the elastic force applied by the main flexures 12 that constrain the main body 11a of the movable mass 11 to the frame structure 15. The amplitude of the force component parallel to the main motion direction X, instead, is not influenced. The detachment of the movable mass 11 is therefore favoured by the induced vibrations, but the restoring force in the main motion direction X is essentially determined by the main flexures 12. The risk that the movable mass 11 will hit the frame structure 15 on the opposite side sticking again is negligible. Furthermore, since the induced vibrations are substantially perpendicular to the main faces of the movable mass 11 (parallel to a plane defined by the barycentric axes B1, B2), the trajectory of the movable mass 11 is not significantly influenced by the forces applied to achieve the detachment. Another advantage of the invention is that, during normal operation in the operating mode, the auxiliary bodies 11b are an integral part of the movable mass 11 and participate in all respects in the sensing.

In the example illustrated, the auxiliary bodies 11b are actuated in-phase with respect to an actuation direction in a plane perpendicular to the first barycentric axis B1. In practice, the auxiliary bodies 11b oscillate in-phase along the actuation direction and are always aligned at the same height with respect to a reference plane defined by the barycentric axes B1, B2. However, it is understood that by using dedicated electrical connections for the recovery electrodes 20, the auxiliary bodies 11b may be actuated with respective distinct phases, to also cause rotary vibrations about the first barycentric axis B1, always in a direction that is transversal to the main motion direction X.

In the example, furthermore, all the auxiliary bodies 11b are actuated simultaneously. However, the auxiliary bodies 11b may also be actuated only on the side of the movable mass 11 stuck against the frame structure 15.

In the embodiment illustrated in Figures 11 and 12, where parts equal to those already shown are indicated with the same reference numbers, the movable bodies 111b are constrained to the main body 111a of the movable mass 111 by auxiliary flexures 118, that allow to translate in an actuation direction DA perpendicular to the main motion direction X and to the plane defined by the barycentric axes B1, B2. The auxiliary flexures 118 are instead configured to prevent relative movements of the auxiliary bodies 111b with respect to the main body 111a in the main motion direction X. Along the main motion direction X, therefore, the auxiliary bodies 111b move rigidly with the main body 111a.

Due to the constraints imposed by the auxiliary flexures 118, electrostatic forces applied in response to a recovery voltage V_{R} cause the auxiliary bodies 111b to translate in the actuation direction DA, perpendicular to the plane defined by the barycentric axes B1, B2.

In the embodiment illustrated in Figures 13 and 14, the movable bodies 211b of the movable mass 211 are constrained to the main body 211a of the movable mass 211 by auxiliary flexures, here indicated by 218, that allow to translate in an actuation direction DA' perpendicular to the main motion direction X and parallel to the second barycentric axis B2. The auxiliary flexures 218 are instead configured to prevent the relative movements of the auxiliary bodies 211b with respect to the main body 211a in the main motion direction X. As in the preceding examples, therefore, the auxiliary bodies 211b move rigidly with the main body 211a along the main motion direction X.

In this case, recovery electrodes 220 may be arranged on internal sides of the frame structure 15 delimiting the cavity 15a, in positions corresponding to respective auxiliary bodies 211b. The recovery electrodes 220 therefore face and are capacitively coupled to the respective auxiliary bodies 211b. The recovery electrodes 220 may be used to apply electrostatic forces to the auxiliary bodies 211b to cause the auxiliary bodies 211b to oscillate in the actuation direction DA', parallel to the second barycentric axis B2 and perpendicular to the main motion direction X. In one embodiment, in particular, the driver 8 is configured to provide recovery voltages V_{R1}, V_{R2} of equal amplitude and in mutual phase-opposition to recovery electrodes 220 opposite with respect to the first barycentric axis B1. In this manner, the electrostatic forces applied to the auxiliary bodies 211b are concordant with each other and the auxiliary bodies 211b move concordant in the same direction parallel to the second barycentric axis B2. In practice, given the arrangement of the recovery electrodes 220, recovery voltages V_{R1}, V_{R2} in phase-opposition cause in-phase movements of the auxiliary bodies 211b parallel to the second barycentric axis B2.

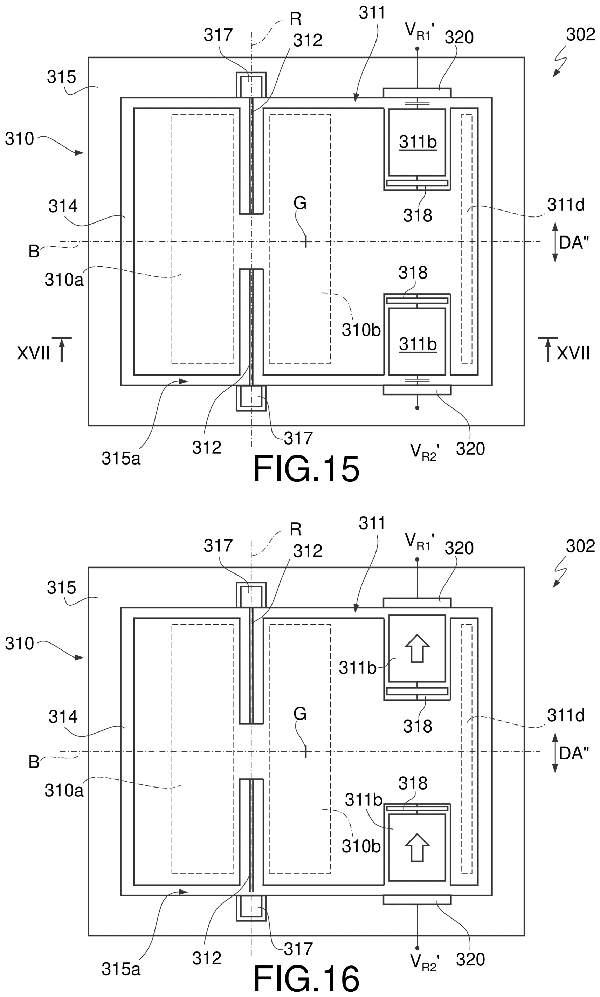

Figures 15-17 illustrate an embodiment of the invention in which the microstructure, herein indicated by 302, comprises a support body indicated by 310 and a movable mass 311. The support body 310 comprises a substrate 314 and a frame structure 315 of semiconductor material, substantially as already described. The frame structure 315 defines a cavity 315a wherein the movable mass 311 is accommodated, at a distance from the substrate 314.

The movable mass 311 is defined by a planar semiconductor plate and is connected to the support body 310 by main flexures 312, configured so that the movable mass 311 may oscillate with respect to the support body 310 about a non-barycentric sense rotation axis R with an out-of-plane movement. In this case, therefore, given the rotary oscillations, the movement of the movable mass 311 occurs along a main motion direction X' perpendicular to a main face of the movable mass 311.

In the embodiment of Figures 15 and 16, the movable mass 311 is capacitively coupled differentially to a first fixed sensing electrode 310a and to a second fixed sensing electrode 310b, which are arranged on the support body 310 in symmetrical positions with respect to the sense rotation axis R and face a lower side of the movable mass 311 (i.e. a side arranged facing the substrate 314).

The movable mass 311 is biased in a known manner to a working potential through the main flexures 312 and anchors 317, which are defined by portions of the frame structure 315 electrically insulated from the rest of the support body 310 and connected to an external bias source through connection lines not shown here for simplicity.

The movable mass 311 comprises a main body 311a, that defines most of the same movable mass 311 and is coupled to the anchors 317 through the main flexures 312, and auxiliary bodies 311b, in turn elastically coupled to the main body 311a through respective auxiliary flexures 318. The main body 311a, the auxiliary bodies 311b and the auxiliary flexures 318 are of the same semiconductor material, for example obtained from a same structural layer of polycrystalline or monocrystalline silicon, and are at the same voltage. In the embodiment of Figures 15-17, in particular, the movable mass 311 comprises two auxiliary bodies 311b on one side of the main body 311a containing the barycentre G. The auxiliary bodies 311b are arranged symmetrically with respect to a barycentric axis B perpendicular to the sense rotation axis R and are coplanar with a main face 311c of the main body 311a.

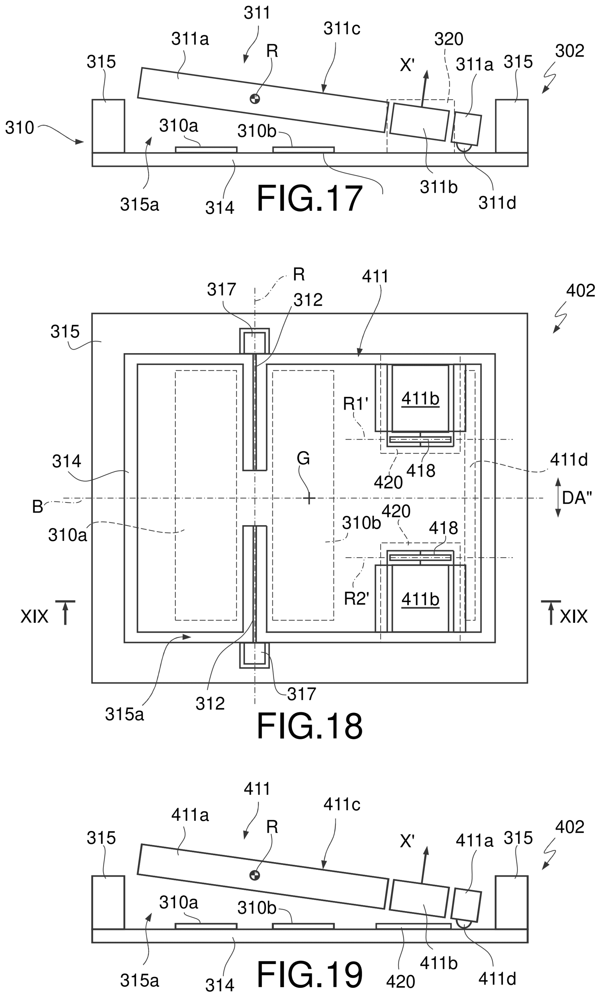

The auxiliary flexures 318 are configured so that the auxiliary bodies 311b are rigidly coupled to the main body 311a with respect to the main motion direction X' (perpendicular to the main face 311c of the main body 311a, see Figure 17); and so that the auxiliary bodies 311b are also movable in a direction that is transversal to the main motion direction X' with respect to the main body 311a. For example, the auxiliary flexures 318 allow the auxiliary bodies 311b to translate in a plane defined by the sense rotation axis R and the barycentric axis B, in particular in a direction parallel to the sense rotation axis R and perpendicular to the barycentric axis B.

The main body 311a of the movable mass 311 is provided with stopper structures 311d at one end of the side containing the barycentre G, so that the stopper structures 311d first come into contact with the substrate 314 due to an over-elongation of the movable mass 311.

The microstructure 302 is also provided with recovery electrodes 320 facing and capacitively coupled to respective auxiliary bodies 311b of the movable mass 311, at least when the movable mass 311 is in the stiction condition. The recovery electrodes 320 are arranged on internal sides of the frame structure 315 delimiting the cavity 315a, in positions corresponding to the respective auxiliary bodies 311b. As in the embodiment of Figures 13 and 14, the recovery electrodes 320 may be used to apply electrostatic forces to the auxiliary bodies 311b to cause the auxiliary bodies 311b to oscillate with in-plane movement. In detail, the electrostatic forces applied by the recovery electrodes 320 are parallel to the sense rotation axis R and perpendicular to the main motion direction X'. In one embodiment, in particular, the recovery electrodes 320 receive recovery voltages V_{R1}', V_{R2}' of equal amplitude and in mutual phase-opposition, the electrostatic forces applied to the auxiliary bodies 311b are concordant with each other and the auxiliary bodies 311b move concordant in the same direction parallel to the sense rotation axis R. In practice, given the arrangement of the recovery electrodes 320, recovery voltages V_{R1}', V_{R2}' in phase-opposition cause in-phase movements of the auxiliary bodies 311b parallel to the sense rotation axis R.

In the embodiment of Figures 18 and 19, the microstructure and the movable mass, here indicated respectively by 402 and 411, have the same general structure as the microstructure 302 and the movable mass 311 of Figures 15-17. In this case, however, the auxiliary bodies 411b are coupled to the main body 411a by auxiliary flexures 418 configured to allow rotations of the auxiliary bodies 411b about rotation axes R1', R2' perpendicular to the sense rotation axis R and parallel to the barycentric axis B (substantially like the auxiliary flexures 18 of the embodiment of Figures 3-6). The auxiliary flexures 418 and the masses of the auxiliary bodies 411b are also configured so that the damped oscillating systems comprising the auxiliary bodies 411b and the respective auxiliary flexures 418 filter frequencies in the operating band B_{OP} of sensable accelerations (normally not higher than 1 kHz and in any case at most a few kHz for particular applications related to the transmission of sounds through solids, such as "Through The Bones" audio applications); and in a recovery frequency band, higher than the operating band, an oscillatory response is allowed, for example with a resonance peak. In this manner, in a normal operating mode, for example due to accelerations in a band up to 2.6 kHz, the auxiliary bodies 411b move together with the main body 411a, substantially as in a rigid motion. At recovery frequencies, for example for recovery voltages V_{R}' of 100 kHz and in any case at least one order of magnitude higher than the frequencies of the operating band, the auxiliary flexures 418 allow the auxiliary bodies 411b to oscillate about the respective rotation axes R1', R2'.

Although in this case the electrostatic recovery forces and, at least for a range of rotation angles, the motion direction of the auxiliary bodies 411b are parallel to the main motion direction X', however the stresses are conveyed to the main body 411a through the auxiliary bodies 411b, that are elastically constrained and oscillating, and are not applied directly. Furthermore, the frequency of the recovery voltage V_{R}' is much higher than the frequencies typically involved in the sense process in the operating mode. In fact, therefore, the action of the electrostatic recovery forces, that are applied indirectly through the auxiliary bodies 411b, is decoupled with respect to the dynamics of the damped oscillating system defined by the movable mass 411 as a whole and by the main flexures 312. The motion of the movable mass 411 after release is therefore not significantly influenced by the electrostatic recovery forces. In accordance with design preferences, it may however be useful to operate the auxiliary bodies 411b in phase-opposition, so that the vibrations are predominantly rotary vibrations.

Finally, it is clear that modifications and variations may be made to the device described herein without thereby departing from the scope of the present invention, as defined in the attached claims.

In particular, the configurations of the support bodies and auxiliary flexures described are not to be considered limiting and may be modified in accordance with design preferences.

Furthermore, for simplicity, embodiments relating to monoaxial microelectromechanical devices have been presented in detail. However, it is understood that the invention equally applies also to multiaxial microelectromechanical devices. In particular, the arrangements of auxiliary bodies and recovery electrodes may be replicated and/or combined to obtain stiction recovery functions along multiple axes.

## Claims

1. A microelectromechanical device comprising:
a support body (10; 310);
a movable mass (11; 111; 211; 311; 411), having a semiconductor main body (11a; 111a; 211a; 311a; 411a), constrained to the support body (10; 310) by first flexures (12; 312) to be able to oscillate according to a main motion direction (X; X'); and
recovery electrodes (20; 220; 320; 420) arranged on the support body (10; 310);
**characterized in that** movable mass (11; 111; 211; 311; 411) comprises a plurality of semiconductor auxiliary bodies (11b; 111b; 211b; 311b; 411b), constrained to the main body (11a; 111a; 211a; 311a; 411a) by second flexures (18; 118; 218; 318; 418), wherein the second flexures (18; 118; 218; 318; 418) are configured to prevent relative movements of the auxiliary bodies (11b; 111b; 211b; 311b; 411b) with respect to the main body (11a; 311a; 411a) according to the main motion direction (X; X') at least in one operating frequency band (B_{OP}) and to allow relative movements of the auxiliary bodies (11b; 111b; 211b; 311b; 411b) with respect to the main body (11a; 311a; 411a) according to an actuation degree of freedom (R1, R2; DA; DA'; DA"; R1', R2') in a recovery frequency band (B_{R}) higher than the operating frequency band (B_{OP});
and **in that** the recovery electrodes (20; 220; 320; 420) are capacitively coupled to respective auxiliary bodies (11b; 111b; 211b; 311b; 411b) at least when the movable mass (11; 111; 211; 311; 411) is in stiction conditions.

2. The microelectromechanical device according to claim 1, comprising a driver (8) configured to apply a recovery voltage (V_{R}; V_{R1}, V_{R2}; V_{R1}', V_{R2}'; V_{R}') in the recovery frequency band (B_{R}) to the recovery electrodes (20; 220; 320; 420).

3. The microelectromechanical device according to claim 2, wherein the recovery electrodes (20; 220; 320) face and are capacitively coupled to the respective auxiliary bodies (11b; 111b; 211b; 311b) so as to apply electrostatic forces transversely to the main motion direction (X; X') in response to the recovery voltage (V_{R}; V_{R1}, V_{R2}; V_{R1}', V_{R2}'; V_{R}').

4. The microelectromechanical device according to any of the preceding claims, wherein the support body (10; 310) comprises a substrate (14; 314) and a frame structure (15; 315), delimiting a cavity (15a; 315a), and wherein the movable mass (11; 111; 211; 311; 411) is defined by a semiconductor planar plate accommodated in the cavity (15a; 315a) at a distance from the substrate (14; 314) and has a main face (11c; 111c; 211c; 311c; 411c).

5. The microelectromechanical device according to claim 4, wherein the first flexures (12) are configured to allow the movable mass (11; 111; 211) to translate in the main motion direction (X) and the main motion direction (X) is coplanar with the main face (11c; 111c; 211c) of the movable mass (11; 111; 211).

6. The microelectromechanical device according to claim 5, the first flexures (312) are configured to allow the movable mass (311; 411) to rotate about a non-barycentric sense rotation axis (R) in the main motion direction (X) and coplanar with the main face (311c; 411c) of the movable mass (311; 411).

7. The microelectromechanical device according to any of claims 4 to 6, wherein the second flexures (18; 418) are configured to allow rotary oscillations of the auxiliary bodies (11b; 411b) about respective recovery rotation axes (R1, R2; R1', R2') coplanar with the main face (11c; 411c) of the movable mass (11; 411).

8. The microelectromechanical device according to claim 7, wherein the recovery rotation axes (R1, R2) are parallel to the main motion direction (X).

9. The microelectromechanical device according to claim 7 dependent on claim 6, wherein the recovery rotation axes (R1', R2') are perpendicular to the sense rotation axis (R).

10. The microelectromechanical device according to claim 8 or 9, wherein the recovery electrodes (20; 420) are arranged on the substrate (14; 314) in positions corresponding to respective auxiliary bodies (11b; 411b).

11. The microelectromechanical device according to any of claims 4 to 6, wherein the second flexures (118; 218; 318) are configured to allow translational oscillations of the auxiliary bodies (111b; 211b; 311b) perpendicularly to the main motion direction (X; X').

12. The microelectromechanical device according to claim 11, wherein the second flexures (118) are configured to allow translational oscillations of the auxiliary bodies (111b) perpendicular to the main face (11c) of the movable mass (11) and wherein the recovery electrodes (20) are arranged on the substrate (14) in positions corresponding to respective auxiliary bodies (111b); or the second flexures (218; 318) are configured to allow translational oscillations of the auxiliary bodies (211b; 311b) coplanar with the main face (11c) of the movable mass (11) and wherein the recovery electrodes (220; 320) are arranged on the frame structure (15) in positions corresponding to respective auxiliary bodies (211b; 311b).

13. The microelectromechanical device according to any of the preceding claims, wherein the second flexures (18; 118; 218; 318) are rigid in the main motion direction (X; X').

14. The microelectromechanical device according to any of claims 1 to 12, wherein the second flexures (418) and the respective auxiliary bodies (411b) define damped oscillating systems wherein rotary oscillations of the auxiliary bodies (411b) about respective recovery rotation axes (R1', R2') are allowed in the recovery frequency band (B_{R}) and are prevented in the operating frequency band (B_{OP}).

15. The microelectromechanical device according to any of the preceding claims, comprising a control device (9) configured to sense stiction conditions, wherein the movable mass (11; 311; 411) is stuck to the support body (10; 310), and to operate the driver (8) in response to the recognition of the stiction conditions.
